# EUROPEAN PATENT APPLICATION

(11) **EP 2 348 544 A2**
(43) Date of publication of application: **27.07.2011**
(21) Application number: 11151713.2
(22) Date of filing: 21.01.2011
(51) Int. Cl.: H01L 31/18, H01L 31/0336, H01L 31/0392, C23C 18/16, H01L 21/368, C25D 11/00, H01L 31/032

(54) **Buffer layer manufacturing method and photoelectric conversion device**

(30) Priority: 22.01.2010 JP 2010012303
(71) Applicant: Fujifilm Corporation, Minato-ku Tokyo (JP)
(72) Inventor: Koike, Takashi, Kanagawa-ken (JP); Kawano, Tetsuo, Kanagawa-ken (JP)
(74) Representative: Klunker . Schmitt-Nilson . Hirsch

(57) **Abstract**

Manufacturing a buffer layer having a uniform composition. In a method of manufacturing a buffer layer of a photoelectric conversion device having a stacked structure in which a lower electrode, a photoelectric conversion semiconductor layer that generates a current by absorbing light, the buffer layer, and a translucent conductive layer are stacked on a substrate, the buffer layer is formed by a CBD method, a pH variation of reaction solution for forming the buffer layer is controlled within 0.5 while deposition of the buffer layer by the CBD method is in progress, and the reaction solution includes a Cd or Zn metal and a sulfur source.

## Description

### BACKGROUND OF THE INVENTION

### Field of the Invention

The present invention relates to a manufacturing method of a buffer layer of a photoelectric conversion device, and the photoelectric conversion device.

### Description of the Related Art

Photoelectric conversion devices having a photoelectric conversion layer and electrodes conducting to the photoelectric conversion layer are used in various applications, including solar cells and the like. Most of the conventional solar cells are Si-based cells using bulk monocrystalline Si, polycrystalline Si, or thin film amorphous Si. Recently, however, research and development of compound semiconductor-based solar cells that do not depend on Si has been carried out. Two types of compound semiconductor-based solar cells are known, one of which is a bulk system, such as GaAs system and the like, and the other of which is a thin film system, such as CIS system formed of a group Ib element, a group IIIb element, and a group VIb element, CIGS, or the like. The CI(G)S system is a compound semiconductor represented by a general formula, C_{U1}-_{z}In₁-ₓGaₓSe₂-ySy (where, 0≤x≤1,0≤y≤1,0≤z≤1 and when x=0 the formula represents a CIS system, while when x>0 it represents a CIGS system. The CIS and CIGS are herein collectively denoted as "CI (G) S".

Conventional thin film photoelectric conversion devices, such as CI (G) S systems and the like, generally include a CdS buffer layer or a ZnS buffer layer, which does not include Cd in view of environmental burden, between a photoelectric conversion layer and a translucent conductive layer (transparent electrode) formed thereon. Roles of the buffer layer may include (1) prevention of recombination of photogenerated carriers (2) band discontinuity alignment (3) lattice matching (4) coverage of surface unevenness of the photoelectric conversion layer, and the like. CI (G) S systems and the like have relatively large surface unevenness, and a CBD (chemical bath deposition) method, which is a liquid phase method, is preferably used in order to satisfy, in particular, the condition of (4) above.

Formation of a buffer layer by the CBD method causes a problem that variations in the characteristics of photoelectric conversion layers are likely to occur depending on the crystalline properties and surface conditions of photoelectric conversion layers, since diffusion of a Zn or Cd component and ZnS or CdS film forming progress at the same time. From this perspective, studies have been made for a method of manufacturing a buffer layer having a uniform composition and various methods for temporally maintaining a composition of a reaction solution constant are proposed.

For example, Japanese Unexamined Patent Publication No. 2002-118068 describes a method in which a plurality of reaction baths is disposed adjacently, and film forming is performed for a predetermined time by dipping a substrate in one of the reaction baths, while sequentially repeating, inparallel to the film forming, replacement of the reaction solution of a reaction bath for which the film forming has been completed. This method, however, does not allow a film forming area of the upper surface of the substrate to be always in contact with a fresh reaction solution. It is, therefore, difficult to maintain the composition uniform over the entire surface of the substrate.

In the mean time, Japanese Patent No. 4320529 describes a method of forming a buffer layer under two different reaction temperatures after diffusing a n-type dopant in a p-type photoelectric conversion layer. Taking note of the fact that a colloidal substance is gradually formed in a strong alkali solution by a chemical reaction when a film is formed by the CBD method, Japanese Unexamined Patent Publication No. 2002-343987 describes a method of preventing the generation of a colloidal substance from the viewpoint that such colloidal substance causes degradation in the film quality and coverage.

It is difficult to form a buffer layer having a substantially uniform composition by the method described in Japanese Patent No. 4320529 because the state of the reaction solution changes as the reaction progresses. In the method described in Japanese Unexamined Patent Publication No. 2002-343987, the state of the reaction solution is supposed to be maintained constant to a certain extent but, in actuality, a buffer layer having a uniform composition is unable to be obtained. The dedicated studies by the present inventors have revealed that the state change in the reaction solution is due to a decomposition reaction of a sulfur source compound of the buffer layer in the reaction solution and thereby the composition of the formed buffer layer is changed in the film thickness direction, which has led to the present invention. It is noted that the decomposition reaction of a sulfur source compound can not be suppressed merely by maintaining the pH in the range from 10 to 13 as described in Japanese Unexamined Patent Publication No. 2002-343987.

The present invention has been developed in view of the circumstances described above, and it is an object of the present invention to provide a buffer layer manufacturing method capable of manufacturing a buffer layer having a uniform composition and a photoelectric conversion device with the buffer layer having a uniform composition.

### SUMMARY OF THE INVENTION

A buffer layer manufacturing method of the present invention is a method of manufacturing a buffer layer of a photoelectric conversion device having a stacked structure in which a lower electrode, a photoelectric conversion semiconductor layer that generates a current by absorbing light, the buffer layer, and a translucent conductive layer are stacked on a substrate,
wherein the buffer layer is formed by a CBD method, a pH variation in a reaction solution for forming the buffer layer is controlled within 0.5 while deposition of the buffer layer by the CBD method is in progress, and the reaction solution includes a Cd or Zn metal and a sulfur source.

Preferably, the pH of the reaction solution is controlled by adding, as required, an aqueous solution which includes at least one of ammonia and ammonium salt. Alternatively, the pH of the reaction solution may be controlled by continuously replacing the reaction solution or by replacing the reaction solution every certain period of time. When the substrate is a flexible substrate, the buffer layer formation may be performed continuously by a roll-to-roll method.

A photoelectric conversion device of the present invention is a device having a stacked structure in which a lower electrode, a photoelectric conversion semiconductor layer that generates a current by absorbing light, a buffer layer, and a translucent conductive layer are stacked on a substrate,
wherein the buffer layer includes a sulfide of a Cd or Zn metal (M), and a variation in molar ratio between the sulfur and the metal (M) of the sulfide in a thickness direction of the buffer layer is within ± 10% with reference to the molar ratio of the buffer layer at the interface between the photoelectric conversion layer and the buffer layer.

Preferably, the buffer layer is at least one type selected from the group consisting of CdS, ZnS, Zn(S, 0), and Zn(S, 0, OH). More preferably, the photoelectric conversion device of the present invention further includes a window layer between the buffer layer and the translucent conductive layer.

Preferably, a major component of the photoelectric conversion semiconductor layer is at least one type of compound semiconductor having a chalcopyrite structure. The term "major component" as used herein refers to a component that accounts for 20% by mass or more.

Preferably, the at least one type of compound semiconductor is a semiconductor formed of at least one type of group Ib element selected from the group consisting of Cu and Ag, at least one type of group IIIb element selected from the group consisting of Al, Ga, and In, and at least one type of group VIb element selected from the group consisting of S, Se, and Te.

Preferably, the substrate is an anodized substrate selected from the group consisting of an anodized substrate formed of an Al-based Al base with an Al₂O₃-based anodized film formed on at least one surface side, an anodized substrate formed of a compound base of a Fe-based Fe material and an Al-based Al material attached to at least one surface side of the Fe material with an Al₂O₃-based anodized film formed on at least one surface side of the compound base, and an anodized substrate formed of a base of a Fe-based Fe material and an Al-based Alfilm formed on at least one surface side of the Fe material with an Al₂O₃₋based anodized film formed on at least one surface side of the base.

The buffer layer manufacturing method of the present invention is a method of manufacturing a buffer layer of a photoelectric conversion device having a stacked structure in which a lower electrode, a photoelectric conversion semiconductor layer that generates a current by absorbing light, the buffer layer, and a translucent conductive layer are stacked on a substrate, wherein the buffer layer is formed by a CBDmethod, a pH variation in a reaction solution for forming the buffer layer is controlled within 0.5 while deposition of the buffer layer by the CBD method is in progress, and the reaction solution includes a Cd or Zn metal and a sulfur source. This may suppress the decomposition reaction of a sulfur source compound because the pH variation of the reaction solution is controlled within 0.5, and the composition variation in a thickness direction of the buffer layer may be prevented effectively.

The photoelectric conversion device of the present invention is a device having a stacked structure in which a lower electrode, a photoelectric conversion semiconductor layer that generates a current by absorbing light, a buffer layer, and a translucent conductive layer are stacked on a substrate, wherein the buffer layer includes a sulfide of a Cd or Zn metal (M), and a variation in molar ratio (S/M) between sulfur and the metal (M) of the sulfide in a thickness direction of the buffer layer is within ± 10% with reference to the molar ratio of the buffer layer at the interface between the photoelectric conversion layer and the buffer layer. Consequently, the composition of the buffer layer in a thickness direction thereof is uniform and the variation in the conversion efficiency of photoelectric conversion devices may be suppressed. If the conversion efficiency variation occurs, a large number of defective products are found in finished product inspection and the yield rate is reduced, resulting in a high manufacturing cost. In contrast, in the photoelectric conversion device of the present invention, the conversion efficiency variation is reduced to a minimum, thereby resulting in a high yield rate and a reduced manufacturing cost.

### BRIEF DESCRIPTION OF THE DRAWINGS

Figure 1 is a schematic cross-sectional view of a photoelectric conversion device according to an embodiment of the present invention.
Figure 2 shows schematic cross-sectional views of two anodized substrates, illustrating the configurations thereof.

### DESCRIPTION OF THE PREFERRED EMBODIMENTS

A buffer layer manufacturing method of the present invention is a method of manufacturing a buffer layer of a photoelectric conversion device having a stacked structure in which a lower electrode, a photoelectric conversion semiconductor layer that generates a current by absorbing light, the buffer layer, and a translucent conductive layer are stacked on a substrate, in which the buffer layer is formed by a CBD method, a variation in the pH of a reaction solution for forming the buffer layer is controlled within 0.5 while deposition of the buffer layer by the CBD method is in progress, and the reaction solution includes a Cd or Zn metal and a sulfur source.

The "CBD method" as used herein refers to a method of depositing a crystal on a substrate at a moderate speed in a stable environment using, as the reaction solution, a metal ion solution having a concentration and a pH that induce supersaturation by the equilibrium represented by a general formula, [M (L) ᵢ] ^{m+} 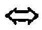 Mⁿ⁺ + iL (where, M is a Cd or Zn metal element, L is the ligand, and m, n, and i are positive numbers) and forming complexes of metal ion M.

As for the method for controlling the variation in the pH of the reaction solution within 0.5, the following three methods are preferable: a method that adds a pH control agent, a method that continuously replaces the reaction solution, and a method that replaces the reaction solution every certain period of time. Hereinafter, each of them will be described. The control of pH variation in the reaction solution refers to that the pH variation is controlled within 0.5 while deposition of the buffer layer is in progress, i.e., from the start to the end of the buffer layer deposition. In the present invention, the reaction solution for forming the buffer layer includes a compound of Cd or Zn metal (M), a sulfur source, and at least one of ammonia and ammonium salt, and the pH of the reaction solution is normally in the range from 11 to 13. It is preferable, therefore, that the pH variation in the reaction solution is controlled within 0.5 in the normal pH range described above.

As for the method that adds a pH control agent to a reaction solution, a method that controls the pH using an aqueous solution, as the pH control agent, which includes, for example, at least one of ammonia and ammonium salt and adding the aqueous solution to the reaction solution properly while monitoring the pH of the reaction solution with a pH controller may be used. The concentration of the pH control agent to be added depends on the total amount of the reaction solution and reaction temperature. Where an aqueous solution of ammonia is added, it is preferable that the aqueous solution is added so that the ammonia concentration in the reaction solution is maintained constant.

Preferably, the reaction temperature is in the range from 70 to 95°C. A reaction temperature below 70°C causes a reduced reaction speed and a thin film does not grow or may grow but it is difficult to obtain a thin film of desired thickness (e.g., 50 nm or greater) at a practical reaction speed. On the other hand, a reaction temperature exceeding 95°C causes many air bubbles to be generated in the reaction solution which may adhere to the surface of the film, whereby the growth of a flat and uniform film is prevented. Further, if the reaction takes place in an open system, a change in the concentration may occur due to evaporation of the solvent, making it difficult to maintain a stable thin film deposition condition. A preferable reaction temperature is 80 to 90°C.

As for the method that continuously replaces the reaction solution, a method in which a substrate on which a photoelectric conversion semiconductor layer is formed (also, simply referred to as substrate) is dipped in a reaction bath which includes a reaction solution and a new reaction solution is supplied at a constant flow rate while an unnecessary reaction solution is discharged so that the pH variation is maintained within 0.5 may be used. For example, the pH variation may be maintained within 0.5 through continuous replacement of reaction solution by providing a system having a reaction bath for dipping a substrate, a reserve tank for holding a reaction solution separately from the reaction bath, a reaction solution supply path connecting between the reserve tank and the reaction bath, and a discharge path for discharging an unnecessary reaction solution, dipping a substrate in the reaction bath containing a reaction solution, and a new reaction solution is supplied from the reserve tank while discharging an unnecessary reaction solution. Here, it is preferable that the new reaction solution is supplied adjacent to the surface of the photoelectric conversion layer of the substrate being dipped. It is also preferable that the new reaction solution to be added is heated to 70 to 95°C, and more preferably, to 80 to 90°C so as not to decrease the temperature of the reaction solution in the reaction bath.

In the case of a so-called roll-to-roll film forming system that uses a supply reel on which a flexible substrate of continuous length is wound in a roll and a take-up reel on which the substrate having a film formed thereon is wound, for example, a new reaction solution adjusted in pH and temperature may be supplied to the reaction bath from the supply reel side and an unnecessary reaction solution may be discharged from the take-up reel side. Where film forming is performed by moving a substrate, being conveyed by a roll-to-roll system, in a stop and go fashion, it is more preferable that a new reaction solution is supplied to the reaction bath and an unnecessary reaction solution is discharged from the take-up reel side of the reaction bath while the substrate is stopped.

According to the method that continuously replaces the reaction solution, the film forming area on the substrate is allowed to contact a fresh reaction solution, and a buffer layer of more uniform composition may be formed. The roll-to-roll film forming system described above allows the use of a flexible substrate, so that a photoelectric conversion device may be manufactured at low cost. In addition, even when photoelectric conversion devices tend to have a larger area, the system can easily adapt to the new situation.

As for the method that replaces the reaction solution every certain period of time, a method in which the pH of a reaction bath in which a substrate is dipped is monitored, then before the pH variation in the reaction solution during deposition reaches 0.5, the reaction bath is replaced with a new reaction bath filled with a new reaction solution, and the replacement is repeated until the deposited film has a desired thickness may be used. Here, it is preferable that the new reaction solution to be filled in a new reaction bath is heated to 70 to 95°C, and more preferably, to 80 to 90°C.

The reaction solution used in the manufacturing method of the present invention includes a Cd or Zn metal (M) and a sulfur source. This allows a CdS, ZnS, Zn(S, O), or Zn(S, O, OH) buffer layer to be formed. As for the sulfur source, for example, thiourea (CS (NH₂)) 2, thioacetamide (C₂H₅NS), and the like may be used.

In the case of a CdS buffer layer, a mixed solution of the sulfur source described above, a Cd compound (e.g., cadmium sulfate, cadmium acetate, cadmium nitrate, cadmium citrate, and hydrates thereof), and ammonia water or ammonium salt (e.g., CH₃COONH₄, NH₄Cl, NH₄I, (NH₄)₂SO₄, and the like) may be used as the reaction solution. In the case of a buffer layer of a Zn compound, such as ZnS, Zn(S, O) , Zn (S, O, OH), and the like, a mixed solution of the sulfur source described above, a Zn compound (e.g., zinc sulfate, zinc acetate, zinc nitrate, zinc citrate, and hydrates thereof), and ammonia water or ammonium salt (those identical to the examples above) may be used as the reaction solution.

Where a Zn compound buffer layer is formed, it is preferable to include a citric acid compound (sodium citrate and/or a hydrate thereof) in the reaction solution. Inclusion of a citric acid compound in the reaction solution causes complexes to be formed easily, whereby crystal growth by the CBD reaction is well controlled and a film may be formed stably.

For a buffer layer manufactured by controlling the pH variation in the reaction solution in the manner as described above, a variation in the molar ratio between the sulfur and the metal (M) in a thickness direction of the buffer layer (S/M) may be kept within the range of ± 10% with reference to the S/M of the buffer layer at the interface between the photoelectric conversion layer and the buffer layer.

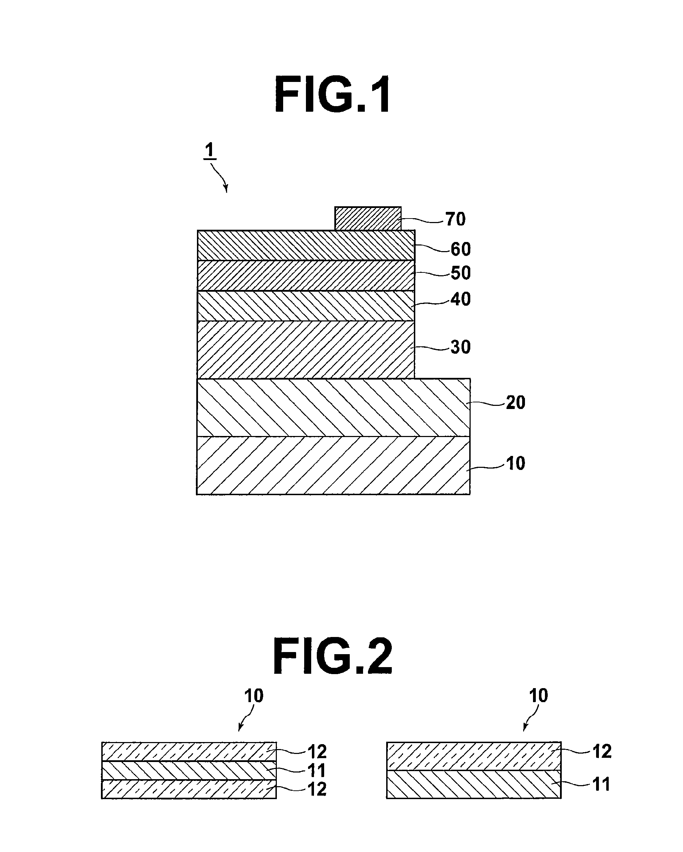

A photoelectric conversion device of the present invention will now be described with reference to the accompanying drawings. Figure 1 is a schematic cross-sectional view of a photoelectric conversion device according to an embodiment of the present invention. In the drawing, each component is not drawn to scale in order to facilitate visual recognition. As illustrated in Figure 1, photoelectric conversion device 1 of the present invention includes substrate 10 on which lower electrode (back contact electrode) 20, photoelectric conversion layer 30, buffer layer 40, window layer 50, translucent conductive layer (transparent electrode) 60, and upper electrode (grid electrode) 70 are stacked in this order.

Substrate 10 is a substrate obtained by anodizing at least one of the sides of base 11. Preferably, base 11 is an Al-based Al base, a composite base of a Fe-based Fe material and an Al-based Al material attached to at least one surface side of the Fe material, or a base of a Fe-based Fe material with an Al-based Al film formed on at least one surface side of the Fe material.

Substrate 10 may be a substrate constituted by base 11 with anodized film 12 formed on each side, as illustrated on the left of Figure 2 or a substrate constituted by base 11 with anodized film 12 formed on either one of the sides, as illustrated on the right of Figure 2. Anodized film 12 is a film consisting primarily of Al₂O₃. Preferably, substrate 10 is a substrate constituted by base 11 with anodized film 12 formed on each side as illustrated on the left of Figure 2 in order to prevent warpage of the substrate due to the difference in thermal expansion coefficient between Al and Al₂O₃, and detachment of the film due to the warpage during the device manufacturing process.

Anodization may be performed by dipping base 11, which is cleaned, smoothed by polishing, and the like as required, as an anode together with a cathode in an electrolyte, and applying a voltage between the anode and the cathode. As for the cathode, carbon, aluminum, or the like is used. There is not any specific restriction on the electrolyte, and an acid electrolyte that includes one type or two or more types of acids, such as sulfuric acid, phosphoric acid, chromic acid, oxalic acid, sulfamic acid, benzenesulfonic acid, amido-sulfonic acid, and the like, is preferably used.

There is not any specific restriction on the anodizing conditions, which are dependent on the electrolyte used. As for the anodizing conditions, for example, the following are appropriate: an electrolyte concentration of 1 to 80% by mass; a solution temperature of 5 to 70°C; a current density of 0.005 to 0.60 A/cm²; a voltage of 1 to 200 V; and an electrolyzing time of 3 to 500 minutes. As for the electrolyte, a sulfuric acid, a phosphoric acid, an oxalic acid, or a mixture thereof may preferably be used. When such an electrolyte is used, the following conditions are preferable: an electrolyte concentration of 4 to 30% by mass, a solution temperature of 10 to 30°C, a current density of 0.05 to 0.30 A/cm², and a voltage of 30 to 150 V.

There is not any specific restriction on the thicknesses of base 11 and anodized film 12. In view of the mechanical strength of substrate 10 and the trend toward thinness and lightness of the device, the thickness of base 11 prior to anodization is, for example, 0.05 to 0.6 mm, and more preferably 0.1 to 0.3mm. When insulation properties, mechanical strength, and the trend toward thinness and lightness are taken into account, a preferable thickness range of anodized film 12 is 0.1 to 100 µm.

There is not any specific restriction on the major component of lower electrode (back contact electrode) 20 and Mo, Cr, W, or a combination thereof is preferably used, in which Mo is particularly preferable. There is not any specific restriction on the thickness of lower electrode (back contact electrode) 20 and 200 to 1000 nm is preferable.

There is not any specific restriction on the major component of photoelectric conversion layer 30. Since high photoelectric conversion efficiency can be obtained, it is preferable that the major component of photoelectric conversion layer 30 is at least one type of compound semiconductor having a chalcopyrite structure, and more preferably the compound semiconductor is a semiconductor formed of a group Ib element, a group IIIb element, and a group VIb element. Preferably, the group Ib element is at least one type of element selected from the group consisting of Cu and Ag, the group IIIb element is at least one type of element selected from the group consisting of Al, Ga, and In, and the group VIb element is at least one type of element selected from the group consisting of S, Se, and Te.

Such compound semiconductors described above include CuAlS_{2,} CuGaS₂, CUInS₂, CuAlSe₂, CuGaSe₂, AgAlS₂, AgGaS₂, AgInS₂, AgAlSe₂, AgGaSe₂, AgInSe₂, AgAlTe₂, AgGaTe₂, AgInTe₂, Cu (In, Al)Se₂, Cu (In, Ga) (S, Se)₂, CU₁-_{z}In₁₋ₓGaₓSe₂-ySy (where, 0≤x≤1, 0≤y≤2, 0≤z≤1 (CI (G) S), Ag(In, Ga)Se₂, Ag (In, Ga) (S, Se)₂, and the like. There is not any specific restriction on the film thickness of photoelectric conversion layer 30, and 1.0 to 3.0 µm is preferable and 1.5 to 2.0 µm is more preferable.

Buffer layer 40 is a layer consisting primarily of CdS, ZnS, Zn (S, O), or Zn (s, O, OH) and is a film formed by the buffer layer manufacturing method of the present invention. There is not any specific restriction on the conductivity type of buffer layer 40 and n-type or the like is preferable. There is not any specific restriction on the film thickness of buffer layer 40, in which 10 nm to 2 µm is preferable and 15 to 200 nm is more preferable.

Window layer 50 is an intermediate layer for introducing light. There is not any specific restriction on the composition of window layer 50, and i-ZnO or the like is preferable. There is not any specific restriction on the film thickness of window layer 50, in which 10 nm to 2 µm is preferable and 15 to 200 nm is more preferable. Window layer 50 is not essential and some of the photoelectric conversion devices do not have window layer 50.

Translucent conductive layer (transparent electrode) 60 functions as a layer for introducing light and allowing a current generated in photoelectric conversion layer 30 to flow therethrough with lower electrode 20 as a pair. There is not any specific restriction on the composition of translucent conductive layer 60, and n-ZnO, such as ZnO:Al, or the like is preferable. There is not any specific restriction on the film thickness of translucent conductive layer 60, and 50 nm to 2 µm is preferable. There is not any specific restriction on the major component of upper electrode (grid electrode) 70, and Al or the like is preferably used. There is not any specific restriction on the film thickness of upper electrode 70, and 0.1 to 3 µm is preferable.

The photoelectric conversion device of the present invention is favorably used for solar cell applications and the like. It can be turned into a solar cell by attaching, as required, a cover glass, a protection film, and the like. Hereinafter, the buffer layer manufacturing method and photoelectric conversion device of the present invention will be described in further detail through examples.

### [Examples]

### (Preparation of Reaction Solution 1)

Reaction Solution 1 was prepared by adding and mixing CdS0₄, thiourea, and ammonia in water such that the concentrations thereof become 0.001M, 0.10M, and 2M respectively.

### (Preparation of Reaction Solution 2)

Reaction Solution 2 was prepared by adding and mixing ZnS0₄, thiourea, sodium citrate, and ammonia in water such that the concentrations thereof become 0.03M, 0.05M, 0.03M, and 0.15M respectively.

### (Manufacture from Substrate to Photoelectric Conversion Layer)

For Examples 1 to 4 and Comparative Examples 1 and 2, a Mo lower electrode was formed on a soda-lime glass (SLG) substrate of 30 mm x 30 mm with a thickness of 0.8 µm by sputtering. Then, a Cu(Ino.₇Ga_{0.3})Se₂ layer was formed on the substrate with a thickness of 1.8 µm by three-stage process which is known as one of the film forming methods for CIGS layers. For Example 5, an Al layer was formed on a 100 µm stainless steel (SUS) substrate with a thickness of 30 µm by sputtering, then an aluminum anodized film (AAO) was formed thereon, and a soda lime glass (SLG) layer and a Mo layer were further formed thereon by sputtering. Then, a Cu(Inₒ.₇Gaₒ.₃)Se₂ layer was formed on the substrate with a thickness of 1.8 µm by three-stage process which is known as one of the film forming methods for CIGS layers.

### (Example 1)

A CdS buffer layer was formed by dipping the substrate with a photoelectric conversion layer formed thereon in a reaction bath containing Reaction Solution 1 adjusted to 80°C, maintaining the pH of the reaction solution constant by monitoring the pH with a pH meter and adding 2.0M ammonia aqueous solution when the pH of the reaction solution in which deposition reaction was in progress, was reduced by 0.4 or more and repeating the addition of the aqueous solution.

### (Example 2)

A CdS buffer layer was formed by dipping the substrate with a photoelectric conversion layer formed thereon in a reaction bath containing Reaction Solution 1 adjusted to 80°C and maintaining the pH of the reaction solution constant by continuously supplying Reaction Solution 1 to the reaction bath from a reserve tank storing Reaction Solution 1 using a peristaltic pump while an unnecessary reaction solution is overflowed and discharged from the reaction bath.

### (Example 3)

A CdS buffer layer was formed by dipping the substrate with a photoelectric conversion layer formed thereon in a reaction bath containing Reaction Solution 1 adjusted to 80°C, monitoring the pH with a pH meter, and when the pH of Reaction Solution 1 in which deposition reaction was in progress was reduced by more than 0.4, totally replacing Reaction Solution 1 with new Reaction Solution 1 adjusted to 80°C.

### (Example 4)

A Zn (S, O) buffer layer was formed in a manner similar to that of Example 1, except that Reaction solution 2 was used instead of Reaction solution 1.

### (Example 5)

A CdS buffer layer was formed in a manner similar to that of Example 1, except that the composition of the substrate with a photoelectric conversion layer formed thereon was changed.

### (Comparative Example 1)

A CdS buffer layer was formed in a manner similar to that of Example 1, except for the pH control.

### (Comparative Example 2)

A CdS buffer layer was formed in a manner similar to that of Example 3, except that when the pH of Reaction Solution 1 in which deposition reaction was in progress was reduced by more than 1.0, Reaction Solution 1 was totally replaced with new Reaction Solution 1 adjusted to 80°C.

### (Evaluation)

### (Film Composition Analysis)

The buffer layers of Examples 1 to 5 and Comparative Examples 1, 2 were subjected to composition analysis by X-ray photoelectron spectroscopy (XPS) while etching the films by sputtering. Areas of peaks corresponding to sulfur (S) and metal (M: Cd or Zn) in a spectrum obtained by emitting an X-ray to the surface of the sample, and a molar ratio of sulfur/metal on the surface of the sample was obtained from the area ratio of each peak. The X-ray emission and spectrum measurement were repeated while etching the surface of the sample until the etching reached the photoelectric conversion layer. The obtained S/M ratios (molar ratios) are compared against the S/M ratio at the interface between the photoelectric conversion layer and the buffer layer, whereby a fluctuation range of the S/M in a thickness direction of the buffer layer was obtained in %.

### (Energy Conversion Efficiency Measurement)

A buffer layer was formed on a substrate in the manner described in each of Examples 1 to 5 and Comparative Examples 1, 2. Then, an i-ZnO layer and an Al--doped n-ZnO layer were formed thereon as window layer and transparent electrode layer respectively. Further, an Al upper electrode layer was formed thereon by a vapor deposition method, whereby a cell for evaluating solar cell characteristics was produced. Ten cells having the same configuration were produced to evaluate the variation in the conversion efficiency. The energy conversion efficiency was measured using pseudo sunlight of Air Mass (AM) = 1.5, 100mW/cm².The evaluation results together with reaction solutions, pH variation, and the like of Examples 1 to 5 and Comparative Examples 1, 2 are shown in Table 1.

| | Example 1 | Example 2 | Example 3 | Example 4 | Example 5 | Comparative Example 1 | Comparative Example 2 |
|---|---|---|---|---|---|---|---|
| Substrate to Photoelectric Conversion Semiconductor Layer | Cu(In₀.₇Ga_{0.3})Se_{2/} Mo/SLG | cu(In0.₇Gao.₃)Se₂/ Mo/SLG | Cu(ln₀.₇Ga_{0 3})Se₂/ Mo/SLG | cu(In_{0.7}Ga₀.₃)Se₂ Mo/SLG | Cu(In_{0.7}Ga₀.₃)Se_{2/} Mo/SLG/AAO/ Al/SUS | Cu(ln₀.₇Ga_{0.3})Se₂/ Mo/SLG | cu(In₀.₇Ga₀.₃)Se₂/ Mo/SLG |
| Type of Reaction Solution | Reaction Solution 1 | Reaction Solution 1 | Reaction Solution 1 | Reaction Solution 2 | Reaction Solution 1 | Reaction Solution 1 | Reaction Solution 1 |
| State of Reaction Solution during CBD Process | pH control agent added by pH controller | Reaction solution supplied continuously | Reaction solution replaced when pH is reduced by 0.4 | pH control agent added by pH controller | pH control agent added by pH controller | Not controlled | Reaction solution replaced when pH is reduced by 1 |
| pH Control Agent | NH₃ aq. | - | - | NH₃ aq. | NH₃ aq. | - | NH₃ aq_ |
| pH of Reaction Solution at Start of Deposition | 12.8 | 12.6 | 12.5 | 128 | 12.7 | 12.7 | 12.6 |
| pH of Reaction Solution 30 min after Start of Deposition | 12.7 | 12.6 | 12.6 | 128 | 12.7 | 11.3 | 12.7 |
| pH Variation During Deposition Period | 0.4 | 0.3 | 0.5 | 0.4 | 0.5 | 1.4 | 1.0 |
| Major Component of Deposited Film | CdS | CdS | CdS | Zn(S,0) | CdS | CdS | CdS |
| S/M Ratio Variation in Film Thickness Direction | ±5.2% | ±4.8% | ±6.7% | ±5.5% | ±6.1% | ±17.6% | ±15.2% |
| Conversion Efficiency Variation | ±3.2% | ±3.6% | ±3.1% | ±3.8% | ±4.2% | ±12.4% | ±11.2% |

As shown in Table 1, in Comparative Example 1 manufactured by a conventional method (manufacturing method without controlling pH), the pH value 30 minutes after the start of deposition of the buffer layer is decreased by 1.4, and both the variation in the S/M ratio (composition variation) and the variation in the conversion efficiency are large. Also, in Comparative Example 2 in which, although the pH variation is controlled, the pH variation while deposition is in progress is 1, variations in both the S/M ratio and conversion efficiency are large. In contrast, in the buffer layers manufactured by the manufacturing method of the present invention, variations in the S/M ratio in a thickness direction of the buffer layers are ±4.8 to ±6.7%, showing that the composition variation is reduced to about 1/3 in comparison with Comparative Examples and variations in the conversion efficiency are within ±5%, showing that the conversion efficiency variation is reduced to as low as about 1/2 in comparison with Comparative Examples.

Although the evaluation was made using ten cells for each example, an actual solar cell module has a configuration in which 100 to 200 of cells used in the example are connected in series. In such a solar cell module, the presence of even one cell of low conversion efficiency restricts the performance of other cells. That is, the characteristics of the solar cell module are cumulative of the characteristics of each cell, so that the reduction of variation in conversion efficiency of each cell is a significant characteristic improvement multiplied by the number of cells for the solar cell module.

Generally, the photoelectric conversion layer is formed of a p-type compound semiconductor while the buffer layer is formed of an n-type semiconductor having a composition quite different from that of the p-type compound semiconductor. Consequently, a defect is likely to occur at the junction between them, and there may be a case in which the composition of the buffer layer is changed continuously in order to improve the junction property as described, for example, Japanese Patent No. 4264801. This may be that the junction property is improved by eliminating the energy barrier between the photoconductive layer and the transparent electrode layer by continuously changing the energy levels of the valence band and conduction band of the buffer layer through inclination of the composition of the buffer layer. Where an i-ZnO layer like that described in the Examples is provided as the window layer, there arises a concern that a defect is likely to occur in the crystal structure inside of the buffer layer and the characteristics of the photoelectric conversion device may be degraded as a consequence if the composition of the buffer layer is inclined, although the junction property between the photoelectric conversion layer and the buffer layer is improved.

In contrast, the present Examples have a buffer layer of uniform composition and there is no concern that the characteristics are degraded. As the energy band from the photoelectric conversion layer to the transparent electrode layer has a stepped structure, provision of an i-ZnO window layer may provide an improved junction property even when the buffer layer has a uniform composition, resulting in both the uniform composition and improved junction property.

## Claims

1. A method of manufacturing a buffer layer (40) of a photoelectric conversion device (1) having a stacked structure in which a lower electrode (20), a photoelectric conversion semiconductor layer (30) that generates a current by absorbing light, the buffer layer (40), and a translucent conductive layer (60) are stacked on a substrate (10),
wherein the buffer layer (40) is formed by a CBD method, a pH variation in a reaction solution for forming the buffer layer (40) is controlled within 0.5 while deposition of the buffer layer (40) by the CBD method is in progress, and the reaction solution includes a Cd or Zn metal and a sulfur source.

2. The method of claim 1, **characterized in that** the pH of the reaction solution is controlled by adding, as required, an aqueous solution which includes at least one of ammonia and ammonium salt.

3. The method of claim 7, **characterized in that** the pH of the reaction solution is controlled by continuously replacing the reaction solution.

4. The method of claim 1, **characterized in that** the pH of the reaction solution is controlled by replacing the reaction solution every certain period of time.

5. The method of any of claims 1 to 4, **characterized in that** the substrate (10) is a flexible substrate and the buffer layer formation is performed continuously by a roll-to-roll method.

6. A photoelectric conversion device (1) having a stacked structure in which a lower electrode (20), a photoelectric conversion semiconductor layer (30) that generates a current by absorbing light, a buffer layer (40), and a translucent conductive layer (60) are stacked on a substrate (10),
wherein the buffer layer (40) includes a sulfide of a Cd or Zn metal (M), and a variation in molar ratio between the sulfur and the metal (M) of the sulfide in a thickness direction of the buffer layer (40) is within ± 10% with reference to the molar ratio of the buffer layer (40) at the interface between the photoelectric conversion layer (30) and the buffer layer (40).

7. The photoelectric conversion device of claim 6, **characterized in that** the buffer layer (40) is at least one type selected from the group consisting of CdS, ZnS, Zn (S, 0) , and Zn (S, O, OH).

8. The photoelectric conversion device of claim 6 or 7, further comprising a window layer (50) between the buffer layer (40) and the translucent conductive layer (60).

9. The photoelectric conversion device of claim 6, 7, or 8, **characterized in that** a major component of the photoelectric conversion semiconductor layer (30) is at least one type of compound semiconductor having a chalcopyrite structure.

10. The photoelectric conversion device of claim 9, **characterized in that** the at least one type of compound semiconductor is a semiconductor formed of at least one type of group Ib element selected from the group consisting of Cu and Ag, at least one type of group IIIb element selected from the group consisting of Al, Ga, and In, and at least one type of group VIb element selected from the group consisting of S, Se, and Te.

11. The photoelectric conversion device of any of claims 6 to 10, **characterized in that** the substrate (10) is an anodized substrate selected from the group consisting of:
an anodized substrate formed of an Al-based Al base with an Al₂O₃-based anodized film formed on at least one surface side;
an anodized substrate formed of a compound base of a Fe-based Fe material and an Al-based A1 material attached to at least one surface side of the Fe material with an Al₂O₃-based anodized film formed on at least one surface side of the compound base; and
an anodized substrate formed of a base of a Fe-based Fe material and an Al-based Al film formed on at least one surface side of the Fe material with an Al₂O₃-based anodized film formed on at least one surface side of the base.

12. The photoelectric conversion device of any of claims 6 to 11, **characterized in that** the substrate is a flexible substrate.
